# EUROPÄISCHE PATENTANMELDUNG

(11) **EP 1 164 397 A1**
(43) Veröffentlichungstag der Anmeldung: **19.12.2001**
(21) Anmeldenummer: 01110401.5
(22) Anmeldetag: 27.04.2001
(51) Int. Cl.: G02B 7/02, G03F 7/20

(54) **Objektivfassung, insbesondere für Projektionsobjektiv in der Halbleiter-Lithographie**

(30) Priorität: 17.06.2000 DE 10030005
(71) Anmelder: Carl Zeiss, 89518 Heidenheim (Brenz) (DE); Carl-Zeiss-Stiftung, trading as Carl Zeiss, 89518 Heidenheim (Brenz) (DE)
(72) Erfinder: Osterried, Karlfrid, Dr., 73431 Aalen (DE)
(74) Vertreter: Lorenz, Werner

(57) **Zusammenfassung**

Bei einem Objektiv (1), insbesondere einem Projektionsobjektiv in der Halbleiter-Lihographie, mit mehreren optischen Elementen, wie Linsen, die in Fassungen gelagert sind, wobei die Fassungen miteinander, gegebenenfalls über Abstimmringe, verbunden sind, ist wenigstens eine Innenfassung (5) eines optischen Elementes (3), das für eine Demontage und/oder eine nachträgliche Montage vorgesehen ist, über eine Dreipunktlagerung (6,7,8,9) mit einer Außenfassung (4) verbunden.

## Beschreibung

Die Erfindung betrifft ein Objektiv, insbesondere Projektionsobjektiv in der Halbleiter-Lithographie nach der im Oberbegriff von Anspruch 1 näher definierten Art.

In der US 5,353,166 ist ein Projektionsobjektiv beschrieben, das aus einer Stapelfassung mit sehr massiven Einzelteilen besteht. Durch die Steifigkeit der massiven Teile soll erreicht werden, daß die Trennfläche nicht deformiert wird. Die Trennung und eine Wiederverbindung besitzt damit eine hohe Reproduzierbarkeit. Die Anschlußflächen sind dabei präzisionsgeschliffen. Das Objektiv ist weiterhin mit Zwischenringen bzw. Abstimmringen versehen.

Bei Hochleistungsobjektiven, wie es z.B. bei Projektionsobjektiven in der Halbleiter-Lithographie der Fall ist, müssen Abbildungsrestfehler nach einer Justage des Objektives minimierbar sein.

Allerdings besteht die Gefahr, daß durch einen nachträglichen Aus- und Einbau von gefaßten Linsen die Abbildungsqualität derartiger Objektive durch mechanische Einflüsse bekannter Fassungstechnik verändert wird. Verursacht wird dies z.B. durch das Losewerden von Abstimmringen beim Öffnen eines Luftraumes, durch dazwischen liegendes Teflonfett, durch Ebenheitsfehler von Fassungen und Abstimmringen und durch unterschiedliche Anzugsmomente an den Schrauben, durch die die Außenfassungen miteinander verbunden sind. Dies bedeutet, daß sich bei einer Demontage und bei einem Einbau der gleichen oder auch einer anderen Linse Einbaufehler als neue Fehler einschleichen können, die die gewünschte Verbesserung hinfällig machen und unter Umständen sogar noch die Qualität verschlechtern.

Der vorliegenden Erfindung liegt daher die Aufgabe zugrunde, ein Objektiv der eingangs erwähnten Art zu schaffen, bei dem nach einem Austausch einer Linse und einem wieder erfolgten Einbau keine neuen Fehler auftauchen bzw. durch die ein reproduzierbarer Wiedereinbau erreicht wird.

Erfindungsgemäß wird diese Aufgabe durch die im kennzeichnenden Teil von Anspruch 1 genannten Merkmalen gelöst.

Durch die erfindungsgemäße Dreipunktlagerung läßt sich eine vollständige Deformationsentkopplung und eine präzise Lagerung erreichen, so daß auch bei einer Demontage und nachfolgenden Wiedermontage reproduzierbare Verhältnisse bzw. eine präzise Einbaulage des neu eingebauten optischen Elementes, wie z.B. einer Linse, erreicht wird, die identisch ist mit der vorangegangenen Lage.

Die Dreipunktlagerung kann aus drei in der Außenfassung angeordneten Lagerkörpern gebildet sein, die mit kugelförmigen Lagerflächen versehen sind, welche in bzw. auf Lagerstellen der Innenfassung gelagert sind. Geeignet hierzu sind z.B. drei Lagerstellen, die aus einer flächigen Auflagestelle, einer rinnenförmigen Auflagestelle und einer Fixpunktauflage gebildet sind.

Erfindungsgemäß sollte dabei die Verlängerung der Längsachse der rinnenförmigen Auflagestelle durch die Fixpunktauflage verlaufen, welche durch ein kegelförmiges Aufnahmeteil gebildet sein kann. Auf diese Weise wird eine sehr präzise definierte Lage geschaffen.

Eine hohe Lagerreproduzierbarkeit kann durch Verwendung von Hartmetallelementen und einer Lösung mit unten bzw. in der Außenfassung sitzenden Kugeln erreicht werden. Die Dreipunktlagerung ist durch das Eigengewicht der gefaßten Linse bei dem Aus/Einbau selbstzentrierend. Dies bedeutet, daß z.B. die neu eingebaute Linse als Korrekturelement selbst nicht mehr nachzentriert werden muß, was die Reproduzierbarkeit weiter verbessert und auch die Einbauarbeiten vereinfacht.

In der Regel werden Objektive in der Halbleiter-Lithographie nicht gekippt und fallen auch nicht um. Aus diesem Grunde wäre keine besondere Fixierung erforderlich. Aus Sicherheitsgründen sollte jedoch die Innenfassung mit einer Sicherungseinrichtung gegen grobes Verschieben oder Herausfallen versehen sein. Wichtig ist dabei jedoch, daß keine Kräfteübertragung auf das optische Element, z.B. die Linse, stattfindet. Dies kann z.B. durch einen Luftspalt von einigen Mikrometern oder durch eine Kleberschicht erfolgen, die jedoch keinen Druck ausüben darf.

Vorteilhafte Weiterbildungen und Ausgestaltungen der Erfindung ergeben sich aus den übrigen Unteransprüchen und aus den nachfolgenden anhand der Zeichnung prinzipmäßig beschriebenen Ausführungsbeispielen.

Es zeigt:
- Figur 1: eine Explosionsdarstellung der erfindungsgemäßen Dreipunktlagerung,
- Figur 2: eine Außenfassung mit konventionellen Abstimmringen,
- Figur 3: eine Außenfassung mit integrierter Abstimmfunktion,
- Figur 4: eine Innenfassung in Verschraubungstechnik,
- Figur 5: eine Sicherungseinrichtung für ein Linsenpaket mit der erfindungsgemäßen Dreipunktlagerung,
- Figur 6: eine Seitenansicht aus Pfeilrichtung A der Figur 5 eines Lagerbockes, und
- Figur 7: einen Versteifungsring mit einer Sicherungseinrichtung.

In einem Objektiv 1 sind in bekannter Weise mehrere Außenfassungen 2 übereinander angeordnet und in nicht näher dargestellter Weise durch Schrauben miteinander verbunden. Eine austauschbare Linse, z.B. eine Korrekturlinse 3, kann über eine Außenfassung 4 mechanisch zur optischen Achse zentriert werden. Falls die Korrekturlinse 3 direkt in den Hauptflansch des Objektivs zu setzen ist, kann die Außenfassung 4 an den Hauptflansch angepaßt werden. Die Korrekturlinse 3 wird in bekannter Weise durch Richtkleben mit einer Innenfassung 5 verbunden. Die Innenfassung 5 trägt hierfür auf der Unterseite einen Tastbund 10, welcher mit einem weiteren Tastbund 10 am Außenumfang der Außenfassung 4 auf Kipp vermessen wird.

Die Außenfassung 4 ist mit oder ohne die Linse 3 in das System der üblichen Stapelfassungen mit den Außenfassungen 2 integrierbar. Auf diese Weise kann die Korrekturlinse 3 zur Kompensierung von Bildfehlern verwendet werden.

Auf der Oberseite der Außenfassung 4 befinden sich drei Hartmetallkugeln als Lagerkörper 6.

Über ihr Eigengewicht wird die Innenfassung 5 mit der Linse 3 als Korrekturelement auf die drei Hartmetallkugeln 6 aufgesetzt. Die Innenfassung 5 trägt hierzu auf ihrer Unterseite eine flächige Auflagestelle 7, eine rinnenförmige Auflagestelle 8 und eine Fixpunktauflage 9, die durch eine kegelförmige Aufnahme gebildet ist. Die Korrekturlinse 3 ist in bekannter Weise durch Federbeinchen 11, die über den Umfang verteilt angeordnet sind, mit der Innenfassung 5 verbunden.

Wie ersichtlich, liegen die Hartmetallkugeln 6 nicht direkt auf der Außenfassung 4, sondern sie sind in Basiselementen 12, die sich unter den Kugeln 6 befinden, positioniert. Durch Dickenkorrekturen der Basiselemente 12 können Kippungen der Innenfassungen 5 vermieden bzw. beseitigt werden. Anstelle einer Anordnung der Basiselemente 12 unter den Kugeln 6, können sich diese auch hinter der flächigen Auflagestelle 7, der rinnenförmigen Auflagestelle 8 und der Fixpunktauflage 9 befinden.

Die Korrekturvorgabe kann nach bekannten Verfahren durch Antastung an den Kippbünden 10 ermittelt werden. Die Basiselemente 12 können durch Läppen auf eine korrekte Dicke gebracht werden. Wenn auch Sicherheitsbügel 13 als Sicherheitseinrichtung auf den Basiselementen 12 montiert bzw. mit diesen verbunden sind, ändert sich ein Aufmaß H der Sicherheitsbügel 13 durch eine Kippkorrektur nicht. Der Sicherheitsbügel, der nach dem Auflegen der ebenen Fassung 5 auf die drei Kugeln 6 aus einer inaktiven Position z.B. eingeschwenkt oder eingeschoben wird, dient als Sicherung gegen ein grobes Verschieben oder Herausfallen der Innenfassung 5. In der Regel werden mindestens zwei oder besser drei Sicherheitsbügel 13 über den Umfang verteilt vorgesehen sein. Damit jedoch keinerlei Kräfteübertragung auf die Linse 3 stattfindet, sollte zur Innenfassung 5 ein Luftspalt von einigen Mikrometern bestehen. Der Luftspalt kann z.B. mit Hilfe einer Metallfolie leicht überprüft werden. Da die Abstimmung nicht über die Innenfassung 5 erfolgt, kann die Höhe H des Sicherheitsbügels 13 genau dem Aufmaß der Innenfassung 5 angepaßt werden.

Zur Anpassung der Außenfassung 4 an die Außenfassungen 2 kann gegebenenfalls auch die Kegelaufnahme 9 der Innenfassung 5 zentrierbar bzw. einstellbar ausgeführt werden. Die Dreipunktlagerung setzt auch die Eigenfrequenz der Korrekturlinse 3 herab. Falls hier Mechanikspezifikationen verletzt werden, kann die Eigenfrequenz durch Versteifung der Innenfassung 5 erhöht werden.

Zur Montage wird die Korrekturlinse 3 in die vormontierte Außenfassung 4 gesetzt. Die Tastbünde 10 werden auf Kipp vermessen, wobei eine Dickenkorrektur von maximal zwei Basiselementen 12 ermittelt und gegebenenfalls eine Korrektur durchgeführt werden kann. Im Unterschied zu dem bekannten Richtklebeverfahren kann auf diese Weise auch ein Restkipp der Linse 3 nach einer Klebung korrigiert werden.

Die erfindungsgemäße Dreipunktlagerung geht in ihrer Grundversion davon aus, daß die Abstimmung der Lufträume zwischen den Linsen wie bisher durch Abstimmringe erfolgt. Dies bedeutet, daß bei Entnahme der Korrekturlinse ein Abstimmring frei wird, dessen Neumontage mit Reproduzierbarkeitsfehlern behaftet ist.

Eine Verbesserung der Dreipunktlagerung kann darin bestehen, daß die Abstimmung von der Abdichtung getrennt wird. Dies bedeutet, daß eine Abstimmung über die Außenfassung 4 der Innenfassung 5 entfällt und die Abstimmung über die Basiselemente 12 durchgeführt wird.

Zur Abstimmung können die Basiselemente 12 entweder nachgearbeitet werden, z.B. durch Läppen oder auch ausgetauscht werden. Die Basiselemente 12 können jedoch auch jeweils einen Schichtstapel aus Metallfolien unterschiedlicher Einzeldicken enthalten, wodurch Dickenänderungen (zur Abstimmung und Tilt/Kipp-Korrektur) besonders einfach durch Entfernen oder Hinzufügen von Folien erreicht werden können.

In Zusammenfassung ergeben sich folgende Vorteile durch die Dreipunktlagerung nach der vorstehend beschriebenen Art:
- eine vollständige Deformationsentkoppelung zwischen Außenfassung 4 und Innenfassung 5
- eine extrem hohe Lagerreproduzierbarkeit in Kipp und Translation
- ein Restkipp ist nach erfolgter Richtklebung der Linse 3 vollständig korrigierbar.

Darüber hinaus ist ein geringer Handlingsaufwand gegeben, da die Lagerung selbstzentrierend ist, ein Festschrauben, Ausrichten und Orientieren eines Abstimmringes entfallen kann, kein Teflonfett erforderlich ist und ein geringeres Gewicht vorliegt. Beim Stand der Technik mußten zur Verbesserung der Reproduzierbarkeit schwere Linsenblöcke bewegt werden.

Um die Korrekturlinse 3 zu entnehmen, muß das Objektiv 1 nur an einer Stelle geöffnet werden.

Die vorstehend beschriebene Dreipunktlagerung kann an mehreren Stellen im Objektiv 1 realisiert werden. Bestehende Fassungen aus gestapelten Außenfassungen 2 können problemlos in ein Korrekturmodul mit einer Korrekturlinse 3 umgewandelt werden. Von Seiten der Mechanik besteht keine Begrenzung hinsichtlich Anzahl und Abfolge von Korrekturmodulen. Als Korrekturmodule sind selbstverständlich nicht nur Korrekturlinsen, sondern auch Korrekturspiegel oder andere optische Elemente möglich. Die beschriebene Dreipunktlagerung kann auch als Standard-Fassungstechnik verwendet werden, um die Vorteile einer vollständigen Deformationsentkopplung und einer Tiltkorrektur zu nutzen. Eine Erweiterung kann auch in einer Abstandsänderung von Linsen über die Basiselemente 22 statt über die bekannten Abstimmringe erfolgen.

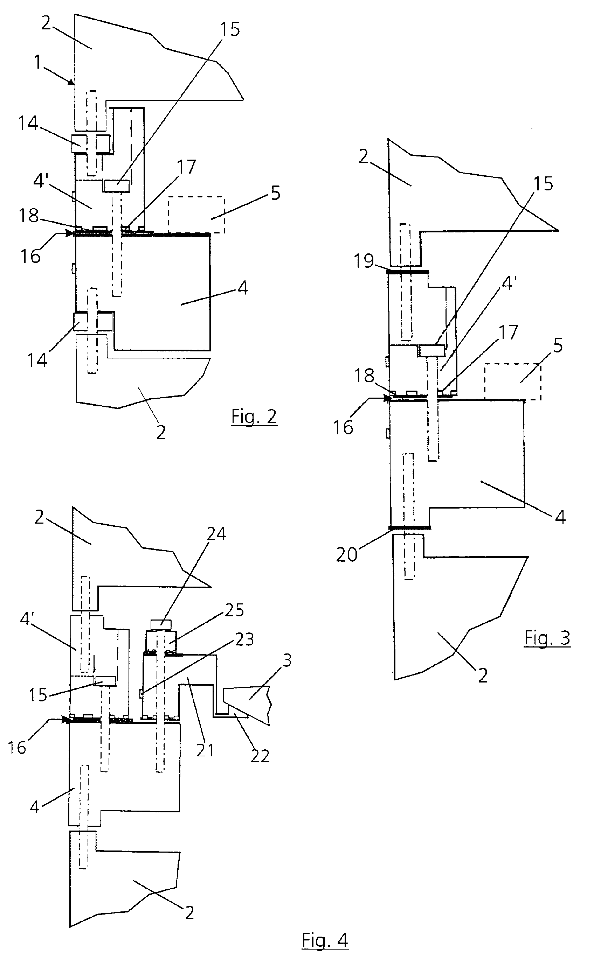

In der Figur 2 ist eine Fassungstechnik dargestellt mit Außenfassungen 4 und dazwischen liegenden konventionellen Abstimmringen 14. Bei der bekannten Fassungstechnik werden durch den Ausbau einer Korrekturlinse 3 auch Abstimmringe 14 frei, wodurch insgesamt acht Trennflächen entstehen. Nach einem Wiedereinbau ist deshalb die Abbildungsqualität meßbar verändert und zwar durch folgende Einflüsse:
- Passefehler der acht Trennflächen (Abstimmringe und Fassungsflansche)
- Trennflächen sind anfällig gegen nicht reproduzierten Einbau von Staub/Verunreinigungen
- Teflonfett, das zur Abdichtung aufgetragen wurde, bildet einen Film endlicher Dicke und kann nicht mehr reproduzierbar aufgetragen werden
- durch Schrauben
- Anzugsmomente erzeugen sehr hohe Presskräfte und verwinden die Fassungen.

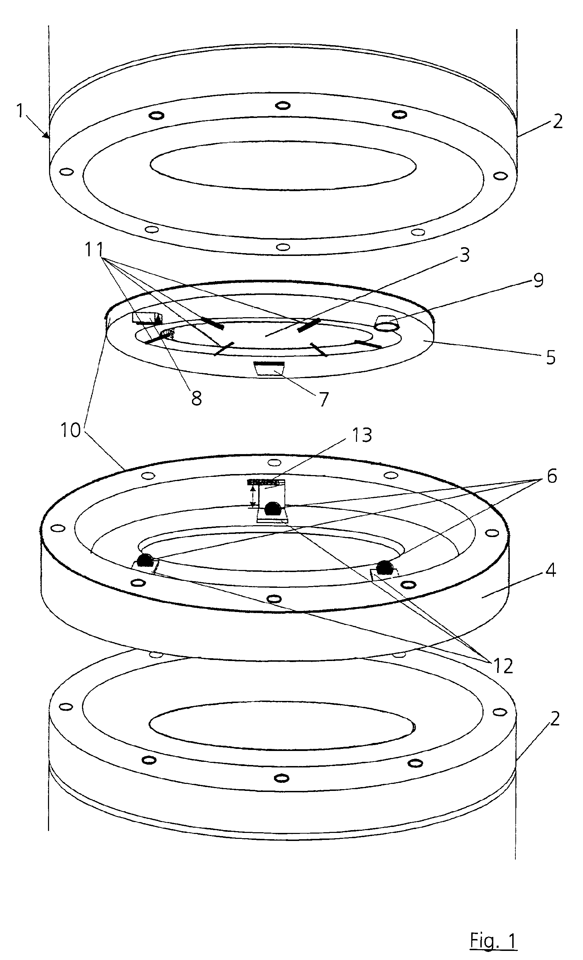

Gemäß Ausführungsbeispiel nach der Figur 2 besteht die Fassungstechnik für den Ausbau einer Korrekturlinse 3 mit ihrer Innenfassung 5 (nur gestrichelt dargestellt) aus zwei Außenfassungen 4 und 4' und einer Innenfassung 5 in der die Korrekturlinse 3 gehalten wird. Zum Öffnen des Objektives 1 für eine Entnahme der Korrekturlinse wird die untere Außenfassung 4 von der Außenfassung 4', die direkt miteinander - ohne Abstimmring - über Schrauben 15 verbunden sind, getrennt. Auf diese Weise kann die Anzahl der durch einen Ausbau bedingten offenen Trennflächen drastisch reduziert werden. Bei einer Montage der Innenfassung 5 über die in Figur 1 dargestellte Dreipunktlagerung wird somit die Anzahl der Trennflächen von acht auf zwei reduziert. Nicht reproduzierbare Montageeinflüsse können weiter reduziert werden durch geläppte Kontaktflächen und ein trockenes Abdichten ohne Teflonfett.

Das obere Fassungsteil 4' fungiert dabei nur als Distanzring, damit der obere Abstimmring 14 beim Öffnen des Objektives an der Trennfläche 16 nicht frei wird.

Das obere Fassungsteil 4' kann auf der Unterseite Freistiche 17 aufweisen und die dazwischen liegenden Flächen sind als geläppte Flächen 18 ausgebildet. Eine Luftraumabstimmung kann in die Außenfassungen 4' und 4 integriert werden.

Die in der Figur 3 dargestellte Außenfassungstechnik ist grundsätzlich von ähnlichem Aufbau wie die in der Figur 2 dargestellte. Gemäß Figur 3 besitzt die Außenfassung 4' in diesem Falle auch die Funktion eines Abstimmringes. Praktisch stellt die Außenfassung 4' einen überdimensionierten Abstimmring dar. Weitere Funktionsflächen 19 und 20 befinden sich jeweils zwischen der oberen Außenfassung 2 und der Fassung 4' und zwischen der unteren Außenfassung 2 und Fassung 4. Die Flächen 19 und 20 werden im Rahmen des Abstimmprozesses auf Maß geschliffen. Der Vorteil der Ausführungsform nach der Figur 3 gegenüber der nach der Figur 2 besteht darin, daß bei begrenztem Bauraum die Fassungen 4 und 4' höher und damit steifer ausgelegt werden können. Die Beeinträchtigung der Passequalität der Funktionsflächen durch Montage ist somit geringer.

Das in der Figur 4 dargestellte Ausführungsbeispiel entspricht im wesentlichen dem der in Figur 3 dargestellten. Anstelle einer Dreipunktlagerung für die Innenfassung 5 der Korrekturlinse 3 ist jedoch hier eine herkömmliche Fassung mit einer deformationsentkoppelten Innenfassung 21 mit Federbeinchen 22 vorgesehen. Dabei wird die Innenfassung 21 über geläppte Flächen an die Fassung 4 geschraubt. Die Innenfassung 21 wird über einen Zentrierbund 23 zentriert. Von Vorteil ist es dabei, wenn alle Kontaktflächen geläppt sind. Hierzu ist auch zwischen der Innenfassung 21 und den über den Umfang verteilten Schrauben 24, über die die Innenfassung 21 mit der Fassung 4 verbunden ist, jeweils ein geläpptes Klötzchen 25 angeordnet. Anstelle einzelner Klötzchen 25 kann auch ein durchgehender, geläppter Ring vorgesehen werden.

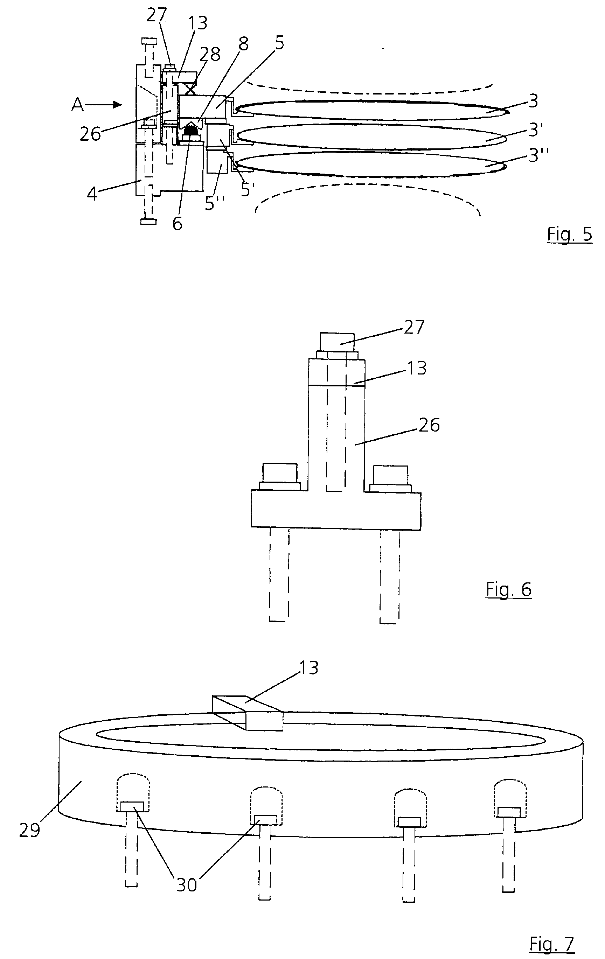

In der Figur 5 ist eine Sicherungseinrichtung für ein Set von drei Linsen dargestellt, wobei die drei Linsen 3, 3' und 3'' gemeinsam über eine Dreipunktlagerung der Innenfassung 5 mit einer Außenfassung 4 verbunden sind. Wie ersichtlich, ist der Bügel 13 an einem Bock 26 angeordnet. Zwei oder drei derartiger Böcke sind in diesem Falle über den Umfang verteilt angeordnet und über Schrauben 27 mit der Fassung 5 verbunden. Sowohl die Innenfassung 4 als auch der Bügel 13 können mit kugel- oder kegelförmigen Erweiterungen 28 versehen werden, um einen genau definierten Abstand bzw. ein Spiel zwischen den beiden Teilen einzustellen. Im Bedarfsfalle kann in den Abstand auch eine Kleberfüllung eingebracht werden. Wesentlich ist lediglich, daß keine Deformationskräfte über die Sicherungseinrichtung auf die Innenfassung 4 aufgebracht werden.

Der übrige Aufbau der Fassungstechnik entspricht der in den vorangegangenen Ausführungsbeispielen beschriebenen Art.

Anstelle von einzelnen Böcken 26 kann auch ein Versteifungsring 29 für den gleichen Zweck vorgesehen werden (siehe Figur 7), welcher über am Umfang verteilt angeordneten Schrauben 30 mit der Außenfassung 5 verbunden wird. Wenigstens ein oder besser zwei bis drei auf der Oberseite des Versteifungsringes 29 angeordnete Bügel 13 stellen wieder die Sicherung gegen ein Herausfallen der Innenfassung 4 her. Gegebenenfalls sind zur Montage und Demontage die Bügel 13 ein- und ausschwenkbar oder ein- und ausschiebbar.

Wie weiterhin aus der Figur 5 noch ersichtlich ist, sind zwar die Linsen 3' und 3'' ebenfalls über Auflagefüßchen 22 in Innenfassungen 5' und 5'' gelagert, aber die beiden Innenfassungen 5' und 5'' sind gemeinsam, gegebenenfalls über Schraubverbindungen, mit der Innenfassung 5 verbunden. Dies bedeutet, daß alle drei Linsen 3, 3' und 3'' gemeinsam bei einer Montage und Demontage der Innenfassung 5 durch die Dreipunktlagerung exakt und reproduzierbar positioniert werden.

Im Rahmen der Erfindung ist der Begriff Fassung bzw. Außenfassung sehr allgemein anzusehen. Neben den zumeist üblichen Richtklebfassungen sind darunter selbstverständlich auch Schraub-/Klemmfassungen, Richtdrehfassungen, pneumatische Fassungen und dergleichen zu verstehen.

## Patentansprüche

1. Objektiv, insbesondere Projektionsobjektiv in der Halbleiter-Lithographie, mit mehreren optischen Elementen, wie z.B. Linsen, die in Fassungen gelagert sind, wobei die Fassungen miteinander, gegebenenfalls über Abstimmringe, verbunden sind, **dadurch gekennzeichnet, daß** wenigstens eine Innenfassung (5) eines optischen Elementes (3), das für eine Demontage und/oder eine nachträgliche Montage vorgesehen ist, über eine Dreipunktlagerung (6,7,8,9) mit einer Außenfassung (4) verbunden ist.

2. Objektiv nach Anspruch 1, **dadurch gekennzeichnet, daß** das optische Element eine Linse (3) ist.

3. Objektiv nach Anspruch 1 oder 2, **dadurch gekennzeichnet, daß** die Dreipunktlagerung aus drei Lagerkörpern (6) gebildet ist, die mit kugelförmigen Lagerflächen versehen sind, welche in Lagerstellen (7,8,9) der Innenfassung (5) oder der Außenfassung (4) gelagert sind.

4. Objektiv nach Anspruch 3, **dadurch gekennzeichnet, daß** die Lagerkörper (6) an der Außenfassung (4) angeordnet sind und daß sich die Lagerstellen (7,8,9) in oder an der Innenfassung (5) befinden.

5. Objektiv nach Anspruch 2, 3 oder 4 **dadurch gekennzeichnet, daß** die drei Lagerstellen aus einer flächigen Auflagestelle (7), aus einer rinnenförmigen Auflagestelle (8) und einer Fixpunktauflage (9) gebildet sind.

6. Objektiv nach Anspruch 5, **dadurch gekennzeichnet, daß** die Verlängerung der Längsachse der rinnenförmigen Auflage (8), durch die Fixpunktauflage (9) verläuft.

7. Vorrichtung nach Anspruch 5 oder 6, **dadurch gekennzeichnet, daß** die Fixpunktauflage (9) als kegelförmiges Auflageteil ausgebildet ist.

8. Objektiv nach einem der Ansprüche 1 bis 7, **dadurch gekennzeichnet, daß** die Lagerkörper (6) durch Kugeln gebildet sind.

9. Objektiv nach einem der Ansprüche 1 bis 8, **dadurch gekennzeichnet, daß** die Lagerkörper (Kugeln 6) höhenverstellbar auf Basiselementen (12), die mit der Außenfassung verbunden sind, aufliegen.

10. Objektiv nach einem der Ansprüche 1 bis 9, **dadurch gekennzeichnet, daß** die Innenfassung (5) gegen ein axiales Verschieben mit einer Sicherungseinrichtung (13) versehen ist.

11. Objektiv nach Anspruch 10, **dadurch gekennzeichnet, daß** die Sicherungseinrichtung (13) wenigstens einen, vorzugsweise drei, über den Umfang verteilt angeordnete Bügel aufweist, die drucklos über dem Innenring liegen.

12. Objektiv nach Anspruch 11, **dadurch gekennzeichnet, daß** die Bügel (13) mit Spiel über der Innenfassung (5) oder einem mit der Innenfassung (5) verbundenen Teil liegen.

13. Objektiv nach Anspruch 11, **dadurch gekennzeichnet, daß** zwischen Bügeln (13) und Innenfassung (5) oder einem mit der Innenfassung verbundenen Teil eine Kleberschicht angeordnet ist.

14. Objektiv nach einem der Ansprüche 11, 12 oder 13, **dadurch gekennzeichnet, daß** die Bügel (13) an drei über den Umfang verteilt angeordneten Lagerböcken (26) angeordnet sind, welche mit der Außenfassung (4) verbunden sind.

15. Objektiv nach einem der Ansprüche 11, 12 oder 13, **dadurch gekennzeichnet, daß** die Bügel (13) an einem Versteifungsring (29) angeordnet sind, der die Innenfassung (5) außenseitig umfaßt und der mit der Außenfassung (4) verbunden ist.

16. Objektiv nach Anspruch 1, **dadurch gekennzeichnet, daß** mehrere optische Elemente (3) über Zwischenfassungen (5',5'') miteinander verbunden und gemeinsam an einer Innenfassung (5) befestigt sind, welche über die Dreipunktlagerung mit der Außenfassung (4) verbunden ist.
